(19) Europäisches Patentamt
European Patent Office
Office européen des brevets

(11) **EP 1 849 223 B1**

(12) **EUROPÄISCHE PATENTSCHRIFT**

(45) Veröffentlichungstag und Bekanntmachung des Hinweises auf die Patenterteilung:
**18.08.2010 Patentblatt 2010/33**

(21) Anmeldenummer: **06708085.3**

(22) Anmeldetag: **08.02.2006**

(51) Int Cl.:
*H02H 3/33* (2006.01)   *H02H 3/17* (2006.01)

(86) Internationale Anmeldenummer:
**PCT/EP2006/050738**

(87) Internationale Veröffentlichungsnummer:
**WO 2006/087277 (24.08.2006 Gazette 2006/34)**

(54) **VORRICHTUNG ZUR INDUKTIVEN GLEICHSTROMERFASSUNG MIT TEMPERATURGANGSKOMPENSATION DER WANDLERPERMEABILITÄT DURCH ANPASSUNG DER FREQUENZ DER EINGEPRÄGTEN WECHSELSPANNUNG**

DEVICE FOR INDUCTIVE DIRECT CURRENT DETECTION AND TEMPERATURE RESPONSE COMPENSATION OF THE CONVERTER PERMEABILITY BY ADAPTING THE FREQUENCY OF THE IMPRESSED ALTERNATING CURRENT

DISPOSITIF DE DETECTION INDUCTIF D'UN COURANT CONTINU ET COMPENSATION THERMIQUE DE LA PERMEABILITE DU CONVERTISSEUR PAR L'ADAPTATION DE LA FREQUENCE DU COURANT ALTERNATIF IMPOSE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **17.02.2005 DE 102005007378**

(43) Veröffentlichungstag der Anmeldung:
**31.10.2007 Patentblatt 2007/44**

(73) Patentinhaber: **SIEMENS AKTIENGESELLSCHAFT**
**80333 München (DE)**

(72) Erfinder:
• **HUBER, Markus**
  **93083 Obertraubling (DE)**
• **GIES, Stefan**
  **93055 Regensburg (DE)**
• **HOFFMANN, Christian**
  **93057 Regensburg (DE)**

(56) Entgegenhaltungen:
**DE-A1- 19 803 684     DE-A1- 19 943 802**

**Beschreibung**

Die Erfindung betrifft eine Vorrichtung zur induktiven Erfassung eines elektrischen Gleichstroms, die insbesondere nach dem Prinzip der gesteuerten Induktivität aufgebaut ist.

Eine derartige Vorrichtung wird beispielsweise in einem allstromsensitiven Differenzstromschutzschaltgerät oder einem allstromsensitiven Fehlerstromschutzschalter verwendet. Das Anwendungsfeld umfasst die Installationstechnik im Gebäudebau und im industriellen Anlagenbau. Bei den genannten Geräten erfolgt eine Differenzstromerfassung mittels einer phasenrichtigen Addition der in mehreren Primärleitern fließenden Ströme. Allstromsensitive Geräte erfassen trotz des induktiven Wirkungsprinzips der eingesetzten Wandler neben Wechsel-Differenzströmen und pulsierenden Gleich-Differenzströmen auch glatte Gleich-Differenzströme. Der Summenstromwandler ist dazu sekundärseitig in einen elektronischen Schaltkreis eingebunden. Eine Wechselsignalquelle speist ein Wechselsignal in einen Spannungsteiler aus der Sekundärwicklung und einem Messwiderstand. Ein primärseitiger Gleichstrom/-anteil beeinflusst die relative Permeabilität des Summenstromwandlers und damit auch die am Messwiderstand abfallende Spannung. Diese Spannung wird ausgewertet und zum Auslösen eines Schaltbefehls herangezogen.

Bei konstanter Temperatur funktioniert diese Auswertung gut. Allerdings weist die relative Permeabilität des Wandlers einen Temperaturgang auf, der bei Temperaturvariationen zu Messfehlern und damit zu Fehlauslösungen führen kann. Bei bekannten Vorrichtungen wird dem Temperaturgang der relativen Permeabilität durch eine besondere Materialwahl für den Wandlerkern, durch eine besondere Arbeitspunkteinstellung und/oder durch eine bei der Auswertung des Messsignals nachträglich erfolgende Temperaturkompensation entgegengewirkt. Dies ist aufwändig, nur in einem relativ engen Temperaturbereich möglich oder schränkt die Freiheitsgrade bei der Auswertung des Messsignals ein.

Aus der DE 198 03 684 A1 ist eine Vorrichtung gemäß dem Oberbegriff des Anspruches 1 bekannt.

Die Aufgabe der Erfindung besteht deshalb darin, eine Vorrichtung zur induktiven Erfassung eines elektrischen Gleichstroms anzugeben, bei der die Temperaturabhängigkeit des induktiven Wandlers mit möglichst einfachen Mitteln und über einen gewissen Temperaturbereich kompensiert ist.

Diese Aufgabe wird gelöst durch die Merkmale des unabhängigen Patentanspruchs 1. Die erfindungsgemäße Vorrichtung umfasst

a) einen induktiven Wandler mit einer vom Gleichstrom durchflossenen Primärwicklung und einer Sekundärwicklung sowie

b) einen Schaltkreis, der als Bestandteile mindestens

aa) die Sekundärwicklung,
bb) eine Wechselsignalquelle zur Einspeisung eines Wechselsignals in die Sekundärwicklung und
cc) ein in Reihe zur Sekundärwicklung geschaltetes Messelement zum Abgriff eines Messsignals

enthält, **dadurch gekennzeichnet, dass**
c) die Wechselsignalquelle Frequenzvariationsmittel zur temperaturabhängigen Veränderung einer Frequenz des Wechselsignals enthält.

Es wurde erkannt, dass sich die Frequenzabhängigkeit der sekundärseitigen Wandlerimpedanz mit Vorteil für eine Temperaturgangskompensation der relativen Permeabilität einsetzen lässt. Die erfindungsgemäße Vorrichtung sieht deshalb eine Wechselsignalquelle vor, deren Wechselsignal eine von der Temperatur abhängige Frequenz aufweist. Dabei ist die Temperaturabhängigkeit dieser Frequenz so gewählt, dass der resultierende Frequenzgang der Wandlerimpedanz gerade der Temperaturabhängigkeit der relativen Permeabilität entgegenwirkt. Sowohl die Frequenz als auch die relative Permeabilität sind Einflussgrößen der Wandlerimpedanz.

Erfindungsgemäß wird die Frequenz des eingespeisten Wechselsignals gezielt mit einem Temperaturgang versehen, sodass die störende Temperaturabhängigkeit der relativen Permeabilität zumindest in einem vergleichsweise großen Temperaturbereich weitgehend kompensiert wird. Diese Kompensation erfolgt unmittelbar im insbesondere als Summenstromwandler ausgeführten induktiven Wandler selbst und ist deshalb besonders effizient. Folglich erübrigt sich eine nachträgliche Temperaturkompensation bei der Auswertung des Messsignals. Die Auswertung kann dann ausschließlich nach anderen Kriterien ausgelegt werden, wodurch sie einfacher, übersichtlicher und auch flexibler in der Handhabung wird.

Vorteilhafte Ausgestaltungen der erfindungsgemäßen Vorrichtung ergeben sich aus den Merkmalen der von Anspruch 1 abhängigen Ansprüche.

Günstig ist eine Variante, bei der die Frequenzvariationsmittel ein temperaturabhängiges Bauelement, insbesondere einen temperaturabhängigen Widerstand, umfassen. Grundsätzlich sind ein Widerstand mit negativem (NTC, Heißleiter) oder positivem (PTC, Kaltleiter) Temperaturkoeffizienten möglich. Die Wahl richtet sich nach dem jeweiligen Anwendungsfall, also nach dem zu kompensierenden Temperaturgang des induktiven Wandlers. Die Temperaturabhängigkeit der relativen Permeabilität kann vom jeweiligen Magnetkernmaterial und auch vom jeweils maßgeblichen Temperaturbereich abhängen. Sowohl Heiß- als auch Kaltleiter sind preiswerte Standard-Bauelemente mit einer hohen Verfügbarkeit.

Weiterhin können die Frequenzvariationsmittel einen Rechteckgenerator mit temperaturabhängiger Periodendauer umfassen. Ein Rechteckgenerator lässt sich leicht mittels eines rückgekoppelten Operationsverstärkers realisieren. Derartige Multivibratorschaltungen sind außerdem preiswert.

Besonders vorteilhaft ist eine Variante, bei der der Rechteckgenerator in einem Rückkopplungszweig einen Widerstand mit negativem Temperaturkoeffizienten, also einen NTC-Widerstand oder Heißleiter, enthält. Ein ohnehin in dem Rückkopplungszweig zur Festlegung der Schwingungsfrequenz vorgesehener Widerstand wird lediglich durch eine temperaturabhängige Widerstandsanordnung mit dem NTC-Widerstand ersetzt, um das günstige temperaturabhängige Frequenzverhalten zu erreichen.

Ein Temperaturgang der relativen Permeabilität und damit des induktiven Wandlers lässt sich besonders gut und auch flexibel nachbilden, wenn der Widerstand mit negativem Temperaturkoeffizienten zusätzlich mit weiteren Widerständen beschaltet ist. Je nach Temperaturgang der relativen Permeabilität kann eine spezifische Beschaltung vorgesehen werden.

Gemäß einer weiteren Variante umfassen die Frequenzvariationsmittel einen Tiefpass. Der Tiefpass ist insbesondere dem Rechteckgenerator nachgeschaltet. Das der Sekundärwicklung des induktiven Wandlers zugeführte in etwa sinusförmige Wechselsignal hat dann im Wesentlichen nur eine einzige Frequenz. Es kann insbesondere diejenige ausgewählt werden, bei der der Temperaturgang der relativen Permeabilität am besten nachgebildet ist. Verfälschungen auf Grund von Frequenzgemischen, deren Einzelfrequenzen ein möglicherweise voneinander abweichendes Temperaturverhalten aufweisen, werden bei nur einer eingespeisten Frequenz verhindert.

Weitere Merkmale, Vorteile und Einzelheiten der Erfindung ergeben sich aus der nachfolgenden Beschreibung von Ausführungsbeispielen anhand der Zeichnung. Es zeigt:

FIG 1    ein Ausführungsbeispiel einer Vorrichtung zur tem- peraturkompensierten Gleichstromerfassung,

FIG 2    Messkurven der relativen Permeabilität eines in der Vorrichtung gemäß FIG 1 eingesetzten induktiven Wandlers bei verschiedenen Temperaturen und

FIG 3    ein Ausführungsbeispiel einer in der Vorrichtung gemäß FIG 1 eingesetzten Wechselsignalquelle mit temperaturabhängiger Frequenz des erzeugten Wech- selsignals.

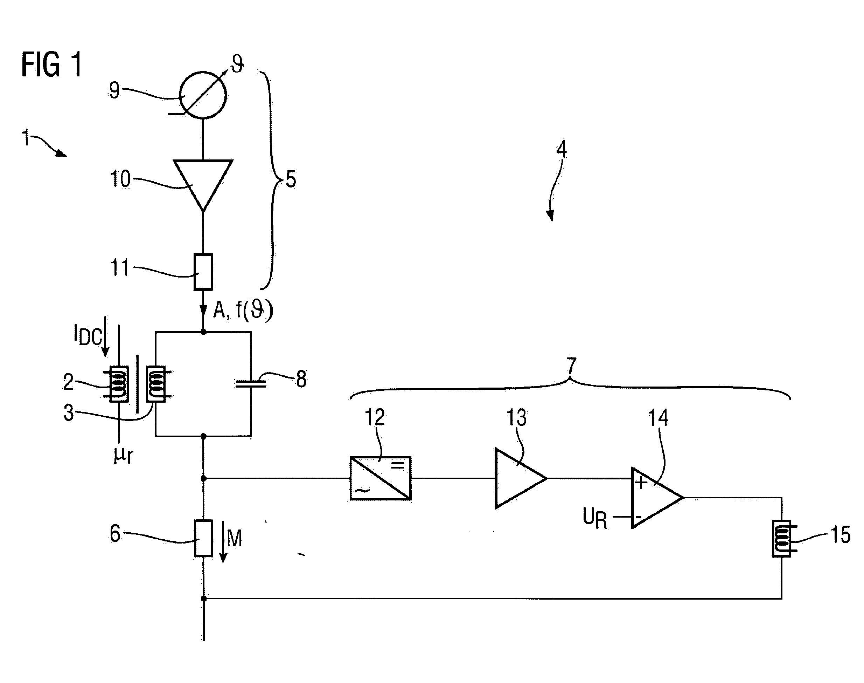

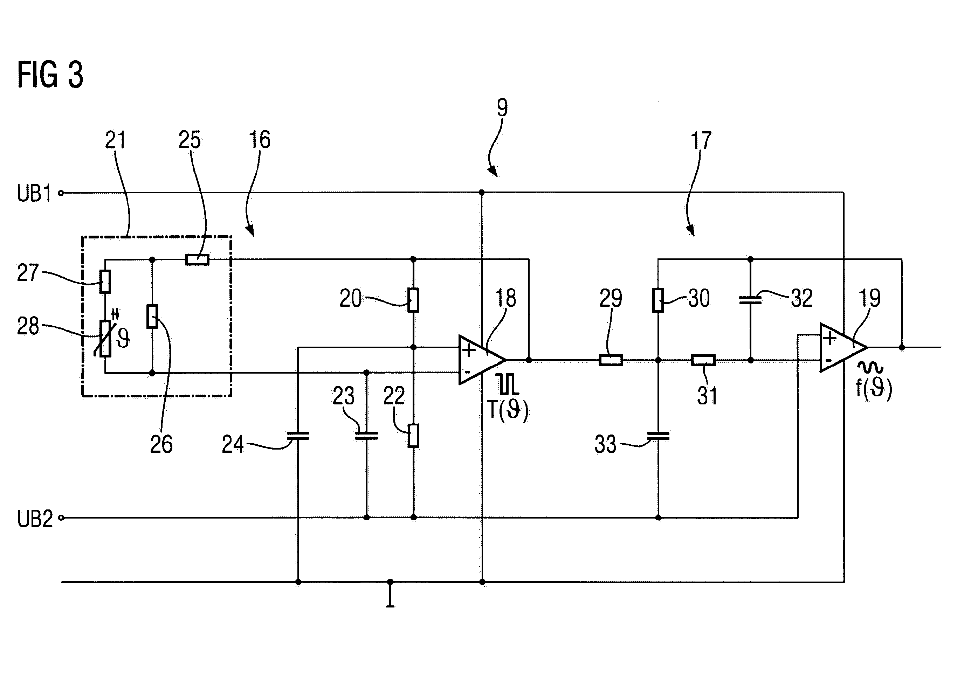

Einander entsprechende Teile sind in den FIG 1 und 3 mit denselben Bezugszeichen versehen.

In FIG 1 ist ein Ausführungsbeispiel einer Vorrichtung 1 zur temperaturkompensierten Gleichstromerfassung dargestellt. Die Vorrichtung 1 ist Teil eines nicht näher gezeigten allstromsensitiven Fehlerstromschutzschalters. Sie umfasst einen Summenstromwandler 2, der primärseitig von einem zu erfassenden Gleichstrom $I_{DC}$ durchflossen wird und sekundärseitig eine Sekundärwicklung 3 aufweist. Weiterer Bestandteil der Vorrichtung 1 ist ein Schaltkreis 4. Er enthält eine Wechselsignalquelle 5, eine Reihenschaltung der Sekundärwicklung 3 und eines ohmschen Messwiderstands 6 sowie eine Auswerteeinheit 7. Zur Erfassung von primärseitigen Wechselströmen oder Wechselstromanteilen ist parallel zur Sekundärwicklung 3 eine Kapazität 8 geschaltet, die bei reiner Gleichstromerfassung grundsätzlich auch entfallen kann.

Die Wechselsignalquelle 5 enthält eine Reihenschaltung aus einer Sinusquelle 9, einem Verstärker 10 sowie einem optionalen ohmschen Vorwiderstand 11. Sie erzeugt ein sinusförmiges Abfragesignal A mit einer von der Temperatur $\vartheta$ abhängigen Frequenz f.

Die an den ohmschen Messwiderstand 6 angeschlossene Auswerteeinheit 7 umfasst einen Gleichrichter 12, einen Verstärker 13, einen Komparator 14 sowie einen Schalt-Auslöser 15 in Form eines Haltemagnets.

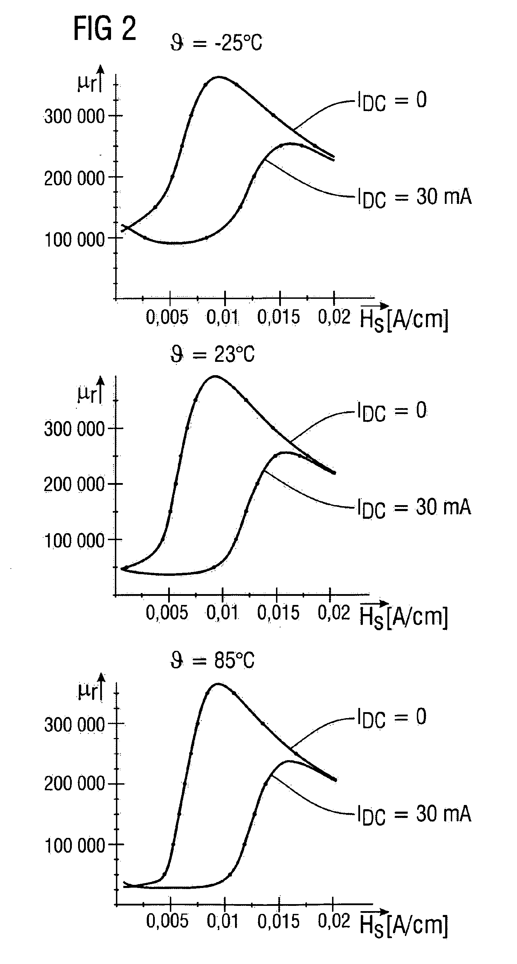

Im Folgenden wird auch unter Bezugnahme auf die Diagramme gemäß FIG 2 die Funktionsweise der Vorrichtung 1 beschrieben.

Das von der Wechselsignalquelle 5 erzeugte Abfragesignal A wird in die Serienschaltung der Sekundärwicklung 3 und des ohmschen Messwiderstands 6 eingespeist. Ein primärseitig fließender Gleichstrom $I_{DC}$ beeinflusst die relative Permeabilität $\mu_r$ des Summenstromwandlers 2 und damit auch eine am Messwiderstand 6 als Messsignal M abfallende Spannung. Das Messsignal M wird in der Auswerteeinheit 7 gleichgerichtet und dann mittels des Verstärkers 13 auf einen Spannungspegel gebracht, der in dem nachgeschalteten Komparator 14 mit einer an einem Vergleichseingang anstehenden Referenzspannung $U_R$ verglichen werden kann. Abhängig vom Ergebnis dieses Vergleichs wird der Schalt-Auslöser 15 mit einem Schaltbefehl beaufschlagt. Liegt der auf der Primärseite des Summenstromwandlers 2 fließende Gleichstrom $I_{DC}$ über einer vorgegebenen Schwelle, öffnet der Schalt-Auslöser 15 einen nicht näher gezeigten Schalter im Primärkreis.

Für den Spannungsabfall am Messwiderstand 6 ist auch eine komplexe Impedanz Z der Sekundärwicklung 3 maßgeblich. Deren Betrag berechnet sich gemäß:

$$|Z| = 2 \cdot \pi \cdot f \cdot L \qquad (1),$$

wobei mit f die aktuelle Frequenz des Abfragesignals A und mit L eine Induktivität der Sekundärwicklung 3 bezeichnet ist. In die Berechnung der Induktivität L gehen verschiedene Parameter ein, die durch den spezifischen Aufbau des Summenstromwandlers 2 bestimmt sind. Unter anderem ist die Induktivität L gemäß:

$$L \propto \mu_r(\vartheta) \qquad (2)$$

proportional zur relativen Permeabilität $\mu_r$. Diese wird durch das für den magnetischen Kern des Summenstromwandlers 2 verwendete Material bestimmt. Sie ist von der Temperatur $\vartheta$ abhängig und kann daher bei variierender Umgebungstemperatur zu Messfehlern und damit Fehlauslösungen führen.

Das Temperaturverhalten der relativen Permeabilität $\mu_r$ geht aus den Messkurven gemäß FIG 2 hervor. Der Verlauf der relativen Permeabilität $\mu_r$ ist jeweils für die Umgebungstemperaturen $\vartheta$ = - 25° C, $\vartheta$ = 23° C und $\vartheta$ = 85° C sowie für die primärseitigen Gleichströme $I_{DC}$ = 30 mA (jeweils untere Kurve) und $I_{DC}$ = 0 (jeweils obere Kurve) dargestellt. Den ersten beiden Diagramme lässt sich entnehmen, dass bei $I_{DC}$ = 30 mA und $\vartheta$ = 23° C der Permeabilitätswert von 40000 auf 80000 ansteigt, wenn die Temperatur $\vartheta$ auf -25° C sinkt. Dies bedeutet, dass der Komparator 14, dessen Referenzspannung $U_R$ entsprechend einem primärseitigen Gleichstrom $I_{DC}$ von 30 mA bei Umgebungstemperatur ($\vartheta$ = 23° C) eingestellt ist, bei einer Temperatur von $\vartheta$ = -25° C erst einen Auslösebefehl abgibt, wenn der primärseitige Gleichstrom $I_{DC}$ einen Wert von 85 mA übersteigt. Ein derartiges Ansteigen der Auslöseschwelle kann zu einer Gefährdung des Nutzers der Vorrichtung 1 führen. Die Funktionssicherheit ist nicht mehr gegeben.

Um dem zu begegnen, erzeugt die Sinusquelle 9 ein Ausgangssignal, dessen Frequenz f von der Temperatur $\vartheta$ abhängt. Wie aus Gleichung (1) ersichtlich, geht in den Impedanzbetrag |Z| nicht nur die Induktivität L und damit die relative Permeabilität $\mu_r$ ein, sondern auch die Frequenz f. Deren Temperaturabhängigkeit f($\vartheta$) ist gerade so ausgelegt, dass sie der Temperaturabhängigkeit der relativen Permeabilität $\mu_r$ entgegenwirkt und diese zumindest in einem vergleichsweise großen Temperaturbereich weitgehend kompensiert.

Ein Ausführungsbeispiel einer schaltungstechnischen Realisierung der Sinusquelle 9 ist in FIG 3 wiedergegeben. Sie enthält einen Rechteckgenerator 16 und einen nachgeschalteten Tiefpass 17 zweiter Ordnung. Beide Teileinheiten sind jeweils mittels eines Operationsverstärkers 18 bzw. 19 aufgebaut, die mit weiteren Bauelementen beschaltet sind. Bei dem Operationsverstärker 18 ist ein auf den positiven Eingang zurückgekoppelter Widerstand 20 und eine auf den negativen Eingang zurückgekoppelte temperaturabhängige Widerstandsanordnung 21 vorgesehen. Darüber hinaus ist der positive Eingang mit einem weiteren Widerstand 22 ebenso wie der negative Eingang mit einer Kapazität 23 an eine Betriebsspannung UB2 geführt. Der Operationsverstärker 18 wird - wie auch der Operationsverstärker 19 - an einer weiteren Betriebsspannung UB1 betrieben. Zwischen den positiven Eingang des Operationsverstärkers 18 und Masse ist außerdem eine Anschwingkapazität 24 geschaltet.

Die temperaturabhängige Widerstandsanordnung 21 besteht aus einer Reihenschaltung eines Vorwiderstands 25 und einer Parallelschaltung eines Parallelwiderstands 26 mit einer Reihenschaltung eines weiteren Vorwiderstands 27 und eines NTC-Widerstands 28. Die Widerstände 25 bis 27 sind so dimensioniert und angeordnet, dass der NTC-Widerstand 28 elektrisch möglichst gering belastet ist. Außerdem ergeben sie einen Gesamt-Temperaturgang der Widerstandsanordnung 21, der dem Temperaturgang der relativen Permeabilität $\mu_r$ in vorteilhafter Weise entgegenwirkt.

Der Operationsverstärker 19 ist mit Widerständen 29, 30 und 31 sowie mit Kapazitäten 32 und 33 beschaltet, sodass sich insgesamt der Tiefpass 17 zweiter Ordnung ergibt.

Im Ausführungsbeispiel gemäß FIG 3 sind folgende Dimensionierungen für die Bauelemente vorgesehen: Der Operationsverstärker 18 ist vom Typ LMC6762 und Operationsverstärker 19 vom Typ LPC682. Der Widerstand 20 hat ebenso wie der Widerstand 22 den Wert 576 kΩ. Der Wert der Kapazität 23 beträgt 10 nF. Die Anschwingkapazität 24 liegt bei 3,3 nF. Für die Widerstände 25 bis 28 der Widerstandsanordnung 21 sind folgende Dimensionierungen vorgesehen: Der Wert des Widerstands 25 liegt bei 453 kΩ, der des Widerstands 26 bei 549 kΩ, der des Widerstands 27 bei 51,1 kΩ und der des NTC-Widerstands 28 bei 100 kΩ. Die Tiefpass-Widerstände 29, 30 und 31 nehmen den Wert 402 kΩ, 806 kΩ bzw. 549 kΩ an. Der Wert der Kapazität 32 und 33 ist 2,2 nF bzw. 10 nF. Für die Betriebsspannungen UB1 und UB2 ist eine Größe von 12 V bzw. 6 V vorgesehen.

Im Folgenden wird die Funktionsweise der Sinusquelle 9 beschrieben. Der Rechteckgenerator 16 erzeugt am Ausgang des Operationsverstärkers 18 ein Rechtecksignal mit einer Periodendauer T gemäß

$$T = 2 \cdot R_\vartheta(\vartheta) \cdot C_2 \cdot \ln\left(1 + \frac{2 \cdot R_1}{R_2}\right) \propto R_\vartheta(\vartheta) \qquad (3),$$

wobei mit $R_1$ der Wert des Widerstands 22, mit $R_2$ der Wert des Widerstands 20, mit $C_2$ der Wert der Kapazität 23 und mit $R_\vartheta(\vartheta)$ der temperaturabhängige Wert der Widerstandsanordnung 21 bezeichnet ist. Gemäß Gleichung (3) ist die Periodendauer T proportional zum Wert der temperaturabhängigen Widerstandsanordnung 21.

Das rechteckförmige Ausgangssignal des Rechteckgenerators 16 wird im nachgeschalteten Tiefpass 17 geglättet, sodass am Ausgang der Sinusquelle 9 ein im Wesentlichen sinusförmiges Signal mit einer einzigen, temperaturabhängigen Frequenz $f(\vartheta)$ ansteht. Die Frequenz f errechnet sich aus dem Kehrwert der Periodendauer T. Mit dieser temperaturabhängigen Frequenz $f(\vartheta)$ ergibt sich der maßgebliche Impedanzbetrag des Summenstromwandlers 2 zu:

$$|Z| = 2 \cdot \pi \cdot \frac{1}{T} \cdot L \propto \frac{1}{R_\vartheta(\vartheta)} \cdot \mu_r(\vartheta) \qquad (4).$$

Der Gleichung (4) ist zu entnehmen, dass die für die Temperaturabhängigkeit der Frequenz f maßgebliche Temperaturabhängigkeit der Widerstandsanordnung 21 gegenläufig zur Temperaturabhängigkeit der relativen Permeabilität $\mu_r$ in den Impedanzbetrag $|Z|$ eingeht. Das Temperaturverhalten der Widerstandsanordnung 21 wird durch den NTC-Widerstand 28 bestimmt, der einen negativen Temperaturkoeffizienten aufweist. Dementsprechend hat auch die Widerstandsanordnung 21 bei niedrigen Temperaturen einen höheren Widerstandswert als bei höheren Temperaturen. Wie vorstehend an Hand der ersten beiden Messkurven von FIG 2 erläutert, steigt die relative Permeabilität bei einer Temperaturabsenkung von $\vartheta = 23°$ C auf $\vartheta = -25°$ C an. Die Temperaturverläufe der Widerstandsanordnung 21 und der relativen Permeabilität $\mu_r$ sind also zumindest in diesem Temperaturbereich gleichläufig Gemäß Gleichung (4) geht die Widerstandsanordnung 21 mit ihrem Kehrwert in die Berechnung des Impedanzbetrags ein, wohingegen die relative Permeabilität $\mu_r$ im Zähler erscheint. Dadurch ergibt sich eine Kompensation der jeweiligen Temperaturgänge.

**Patentansprüche**

1.   Vorrichtung zur induktiven Erfassung eines elektrischen Gleichstroms ($I_{DC}$) umfassend

   a) einen induktiven Wandler (2) mit einer vom Gleichstrom ($I_{DC}$) durchflossenen Primärwicklung und einer Sekundärwicklung (3) sowie
   b) einen Schaltkreis (4), der als Bestandteile mindestens

      aa) die Sekundärwicklung (3),
      bb) eine Wechselsignalquelle (5) zur Einspeisung eines Wechselsignals (A) in die Sekundärwicklung (3) und
      cc) ein in Reihe zur Sekundärwicklung (3) geschaltetes Messelement (6) zum Abgriff eines Messsignals (M) enthält, **dadurch gekennzeichnet, dass**

   c) die Wechselsignalquelle (5) Frequenzvariationsmittel (9) zur temperaturabhängigen Veränderung einer Frequenz (f) des Wechselsignals (A) enthält.

2.   Vorrichtung nach Anspruch 1, **dadurch gekennzeichnet, dass** die Frequenzvariationsmittel (9) ein temperaturabhängiges Bauelement, insbesondere einen temperaturabhängigen Widerstand (28), umfassen.

3.   Vorrichtung nach Anspruch 1 oder 2, **dadurch gekennzeichnet, dass** die Frequenzvariationsmittel (9) einen Rechteckgenerator (16) mit temperaturabhängiger Periodendauer (T) umfassen.

4.   Vorrichtung nach Anspruch 3, **dadurch gekennzeichnet, dass** der Rechteckgenerator (16) in einem Rückkopplungszweig einen Widerstand (28) mit negativem Temperaturkoeffizienten enthält.

5. Vorrichtung nach Anspruch 4, **dadurch gekennzeichnet, dass** der Widerstand (28) mit negativem Temperaturkoeffizienten zur Nachbildung eines Temperaturgangs des induktiven Wandlers mit weiteren Widerständen (25, 26, 27) beschaltet ist.

6. Vorrichtung nach einem der vorhergehenden Ansprüche, **dadurch gekennzeichnet, dass** die Frequenzvariationsmittel (9) einen Tiefpass (17) umfassen.

**Claims**

1. Device for inductive detection of an electrical direct current ($I_{DC}$) comprising

   a) an inductive converter (2) with a primary winding through which direct current ($I_{DC}$) flows and a secondary winding (3) and also
   b) a circuit (4), containing as its components at least

      aa) the secondary winding (3),
      bb) an alternating signal source (5) for feeding an alternating signal (A) into the secondary winding (3) and
      cc) a measurement element (6) connected in series to the secondary winding (3) for tapping off a measurement signal (M), **characterised in that**

   c) the alternating signal source (5) contains frequency variation means (9) for temperature-dependent variation of a frequency (f) of the alternating signal (A).

2. Device according to claim 1, **characterised in that** the frequency variation means (9) comprises a temperature-dependent component, especially a temperature-dependent resistor (28).

3. Device according to claim 1 or 2, **characterised in that** the frequency variation means (9) comprises a square wave generator (16) with a temperature-dependent period of oscillation (T).

4. Device according to claim 3, **characterised in that**, in a feedback branch the square wave generator (16) contains a resistor (28) with negative temperature coefficient.

5. Device according to claim 4, **characterised in that** the resistor (28) with negative temperature coefficient is connected to further resistors (25, 26, 27) for emulating a temperature response of the inductive converter.

6. Device according to one of the previous claims, **characterised in that** the frequency variation means (9) comprises a lowpass filter (17).

**Revendications**

1. Dispositif de détection d'un courant électrique continu ($I_{DC}$) par induction, comprenant

   a) un convertisseur inductif (2) avec un enroulement primaire traversé par le courant continu ($I_{DC}$) et un enroulement secondaire ainsi que
   b) un circuit (4) dont les composants sont au moins

      aa) l'enroulement secondaire (3),
      bb) une source de signaux alternatifs (5) pour injecter un signal alternatif (A) dans l'enroulement secondaire (3) et
      cc) un élément de mesure (6) monté en série avec l'enroulement secondaire (3) pour prélever un signal de mesure (M),

   **caractérisé en ce que**
   c) la source de signaux alternatifs (5) contient des moyens de variation de fréquence (9) pour modifier une fréquence (f) du signal alternatif (A) en fonction de la température.

**2.** Dispositif selon la revendication 1, **caractérisé en ce que** les moyens de variation de fréquence (9) comportent un composant dépendant de la température, et plus particulièrement une résistance dépendante de la température (28).

**3.** Dispositif selon la revendication 1 ou 2, **caractérisé en ce que** les moyens de variation de fréquence (9) comprennent un générateur rectangulaire (16) avec une durée de période (T) dépendante de la température.

**4.** Dispositif selon la revendication 3, **caractérisé en ce que** le générateur rectangulaire (16) contient, dans une branche de rétrocouplage, une résistance (28) avec un coefficient de température négatif.

**5.** Dispositif selon la revendication 4, **caractérisé en ce que** la résistance (28) avec un coefficient de température négatif est câblée à d'autres résistances (25, 26, 27) pour reproduire une évolution de température du convertisseur inductif.

**6.** Dispositif selon l'une des revendications précédentes, **caractérisé en ce que** les moyens de variation de fréquence (9) incluent un passe-bas (17).

# FIG 1

EP 1 849 223 B1

# FIG 2

$\vartheta = -25°C$

$\vartheta = 23°C$

$\vartheta = 85°C$

# FIG 3

EP 1 849 223 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19803684 A1